# EUROPÄISCHE PATENTSCHRIFT

(11) **EP 1 457 762 B1**
(45) Veröffentlichungstag und Bekanntmachung des Hinweises auf die Patenterteilung: **26.09.2007**
(21) Anmeldenummer: 04004611.2
(22) Anmeldetag: 28.02.2004
(51) Int. Cl.: G01D 5/04, G01D 5/347, H03M 1/00

(54) **Vorrichtung zur Messung der Position, des Weges oder des Drehwinkels eines Objektes**
Device for measuring the position, the displacement or the rotational angle of an object
Dispositif pour mesurer la position, le déplacement ou l'angle de rotation d'un objet

(30) Priorität: 13.03.2003 DE 10310970
(43) Veröffentlichungstag der Anmeldung: 15.09.2004
(73) Patentinhaber: SICK STEGMANN GmbH, 78166 Donaueschingen (DE)
(72) Erfinder: Siraky, Josef, 78166 Doaueschingen (DE)
(74) Vertreter: Patentanwälte Westphal, Mussgnug & Partner

(56) Entgegenhaltungen:
- EP-A- 0 046 232
- DE-A- 19 821 467
- FR-A- 2 697 081
- US-A- 4 572 951
- US-A- 4 712 088
- US-A- 4 733 116

## Beschreibung

Die Erfindung betrifft eine Vorrichtung zur Messung der Position, des Weges oder des Drehwinkels eines Objektes gemäß dem Oberbegriff des Anspruchs 1.

Für eine Vielzahl von Anwendungen ist es erforderlich, die Position eines Objektes und/oder den von einem Objekt zurückgelegten linearen Weg oder Drehwinkel in Bezug auf ein Referenzsystem, z. B. in Bezug auf ein anderes Objekt, zu messen. Hierzu ist es bekannt, eine Maßverkörperung mit dem zu messenden Objekt und diese Maßverkörperung durch eine mit dem Referenzsystem verbundene Abtastung abzutasten. Bei einem linear bewegbaren Objekt kann die Maßverkörperung als Lineal ausgebildet sein, bei einem rotierenden Objekt als Winkelteilung einer rotierenden Scheibe. Die Abtastung der Maßverkörperung kann optisch in Transmission oder Reflexion oder magnetisch erfolgen.

Bei vielen Anwendungen sind lange Wege bzw. große Drehwinkel des Objektes zu messen. Um in solchen Fällen einen absoluten Positionswert mit hoher Genauigkeit zu messen, ist es bekannt, die Maßverkörperung mit einer hohen Genauigkeit einem begrenzten Positionsbereich zuzuordnen und die Messung in aufeinanderfolgenden Positionsbereichen durch die Maßverkörperung zyk lisch zu wiederholen. Dieses Prinzip wird insbesondere bei sog. Multiturn-Drehwinkel-Messgeräten verwendet, bei welchen mittels der Maßverkörperung die Winkelposition innerhalb einer Umdrehung absolut gemessen wird, während eine zusätzliche Codiereinheit die Anzahl der Umdrehungszyklen der Maßverkörperung bestimmt.

Zur Codierung der Zyklen ist es bekannt, die Bewegung der Maßverkörperung über Untersetzungsgetriebe auf Codescheiben zu übertragen, die die Anzahl der Zyklen vorzugsweise absolut codiert anzeigen. Bei den bekannten Vorrichtungen treibt dabei jeweils eine Codescheibe der Codiereinheit die nachfolgende Codescheibe über das Untersetzungsgetriebe mit einem Untersetzungsverhältnis von 1:2ⁿ an. Pro Umdrehung einer Codescheibe wird somit die nachfolgende Codescheibe um einen Winkelschritt weiter gedreht, d. h. jede Codescheibe bestimmt die vollen Umdrehungen der vorangehenden Codescheibe. Bei einer mehrstufigen Codiereinheit vergrößert sich der Platzbedarf.

Aus der DE 198 21 467 A1 ist es bekannt, die Anzahl der Umdrehungen einer Welle eines Multiturn-Drehwinkelgebers mit hoher Auflösung absolut zu messen, indem ein auf der Welle sitzendes Antriebszahnrad in Form eines Differenzzahngetriebes zwei koaxial angeordnete Zahnräder mit unterschiedlichen Zahnzahlen antreibt. Die Codierungen der angetriebenen Zahnräder liegen in axial gegeneinander versetzten Ebenen.

Aus der FR-A-2 697 081 ist es bekannt, die Winkelposition einer Welle über mehrere Umdrehungen hochauflösend zu messen, indem Antriebszahnräder der Welle als Differenzzahngetriebe Codescheiben mit einer Verzahnung unterschiedlicher Zahnzahlen antreiben. Die Codescheiben weisen Codespuren auf, die radial gegeneinander versetzt auf den einander zugewandten Seiten der Codescheiben angeordnet sind. Die Codescheiben bestehen aus einem transparenten Material, so dass sie durchstrahlt und optisch abgetastet werden können. Die Codescheiben sind auf einer gemeinsamen mittigen Achse gelagert. Es können nur zwei Codescheiben verwendet werden.

Aus der EP-A-0 046 232 ist ein Multiturn-Winkelcodierer bekannt, bei welchem mehrere Codescheiben koaxial angeordnet sind. Die Codescheiben werden mit unterschiedlicher Drehzahl durch einen gemeinsamen Zahnriemen angetrieben. Jede Codescheibe wird durch eine axial zwischen den Codescheiben angeordnete Abtastung optisch abgetastet, wodurch sich eine große axiale Baulänge ergibt.

Aus der US-A-4,572,951 ist ein Multiturn-Drehgeber bekannt, bei welchem die Umdrehungen der Welle über Differenzzahngetriebe gezählt werden. Die Getriebezahnräder und die Codescheiben sind dabei mit parallel gegeneinander versetzten Achsen angeordnet, wodurch sich größere Bauabmessungen ergeben.

Der Erfindung liegt die Aufgabe zugrunde, eine Vorrichtung der eingangs genannten Gattung so auszubilden, dass bei kostengünstigem und platzsparendem Aufbau eine große Zahl von Messwertzyklen der Maßverkörperung gemessen werden kann.

Diese Aufgabe wird erfindungsgemäß gelöst durch eine Vorrichtung mit den Merkmalen des Anspruchs 1.

Vorteilhafte Ausführungen der Erfindung sind in den Unteransprüchen angegeben.

Der wesentliche Gedanke der Erfindung besteht darin, die Messwertzyklen der Maßverkörperung mittels einer Codiereinheit zu bestimmen, bei welcher die jeweils aufeinander folgenden Codescheiben durch ein Differenzzahngetriebe gekuppelt sind. Während bei dem bekannten Stand der Technik jede Codescheibe die nachfolgende über ein Untersetzungsgetriebe antreibt und somit jede Codescheibe die vollen Umdrehungen der vorangehenden Co-descheibe zählt, werden bei der erfindungsgemäßen Vorrichtung jeweils zwei aufeinanderfolgende Codescheiben von dem gleichen Antriebszahnrad angetrieben, wobei die beiden Codescheiben jedoch eine unterschiedliche Anzahl von Zähnen aufweisen, sodass sie sich mit unterschiedlicher Geschwindigkeit drehen. Die Anzahl der Umdrehungen des Antriebszahnrades und damit die Zahl der durchlaufenen Messwertzyklen der Maßverkörperung ergibt sich dabei aus der gegenseitigen Winkelposition der Codescheiben nach dem Nonius- oder Vernier-Prinzip.

Der Antrieb der Codescheiben über ein Differenzzahngetriebe ermöglicht einen besonders kompakten Aufbau der Codiereinheit, da die Codescheiben koaxial angeordnet werden können. Die Codescheiben weisen dabei Kreisringscheiben auf, die die Codespuren der Winkelcodierung tragen. Diese Kreisringscheiben sämtlicher Codescheiben sind konzentrisch in einer gemeinsamen Ebene angeordnet. Mit diesen Kreisringscheiben sind kreisringförmig ausgebildete Zahnräder verbunden. Die Zahnräder der einzelnen Codescheiben sind dabei axial aneinander anschließend angeordnet. Die Kreisringscheiben mit den Codespuren befinden sich im freien Innenraum der kreisringförmigen Zahnräder, so dass ein gemeinsamer Lichtsender die Codespuren sämtlicher Codescheiben durchstrahlen kann. Ebenso ist eine die Codespuren sämtlicher Codescheiben radial überdeckende Abtastung vorgesehen. Die konzentrische Anordnung der Codespuren sämtlicher Codescheiben in Verbindung mit der axial gestapelten Anordnung der zugehörigen Zahnräder ergibt einen außerordentlich kompakten Aufbau der Codiereinheit. Dadurch ist es sogar möglich, die Codiereinehit insgesamt als Elektronikbauteil auszubilden, welches auf eine Leiterplatte gelötet werden kann (z.B. im SMD-, Chip-on-board- oder Ball Grid- Technik).

Die Codescheiben mit ihrer die Codespur tragenden Kreisringscheibe und dem Zahnrad können als einstückiges KunststoffSpritzgußteil hergestellt werden, so dass sich auch besonders vorteilhafte Herstellungs- und Montagekosten ergeben. Nachfolgend wird die Erfindung anhand eines in der Zeichnung dargestellten Ausführungsbeispiels näher erläutert. Es zeigen:
Figur 1
   Die Codiereinheit im Axialschnitt in einer ZusammenstellungsZeichnung,
Figur 2
   Einen Axialschnitt der zusammengebauten Codiereinheit und
Figuren 3 und 4
   eine erläuternde Darstellung des Funktionsprinzips der Codierung.

Die in der Zeichnung dargestellte Codiereinheit dient zum codierten Bestimmen der Anzahl der von einer nicht dargestellten Maßverkörperung durchlaufenen Anzahl von Messwertzyklen. Beispielsweise kann die Anzahl der Umdrehungen der die Maßverkörperung tragenden Codescheibe eines Multiturn-Drehwinkelgebers bestimmt werden.

Die Codiereinheit weist ein Gehäuse 1 auf. Dieses Gehäuse 1 besteht aus einer als Leiterplatte ausgebildeten Grundplatte 10, einem auf die Grundplatte 10 aufgesetzten hohlzylindrischen Gehäuseteil 11 aus Kunststoff und einem das Gehäuseteil 11 an der der Grundplatte 10 entgegengesetzten Stirnfläche abschließenden Deckplatte 12, die ebenfalls als Leiterplatte ausgebildet ist.

Auf der Grundplatte 10 ist eine Drehachse 13 angebracht, die in das Gehäuseteil 11 parallel und exzentrisch zu der Achse des Gehäuseteils 11 hineinragt. Angrenzend an die Grundplatte 10 sitzt auf der Drehachse 13 frei drehbar ein Eingangszahnrad 20, welches mit seiner Umfangszahnung aus dem Gehäuse 1 herausragt und mit einer nicht dargestellten, mit der Maßverkörperung verbundenen Zahnung in Eingriff kommt. An das Eingangszahnrad 20 ist koaxial einstückig ein erstes Antriebszahnrad 21 angeformt.

In dem zylindrischen Gehäuseteil 11 sind koaxial zueinander und axial aneinander anschließend drei Codescheiben 3, 4 und 5 gelagert. Die Codescheiben 3, 4 und 5 sind jeweils einstückig aus transparentem Kunststoff gespritzt.

Die der Grundplatte 10 am nächsten liegende erste Codescheibe 3 weist ein kreisringförmig ausgebildetes Zahnrad 30 auf, welches mit seiner am Außenumfang angebrachten Zahnung mit der Zahnung des ersten Antriebszahnrads 21 in Eingriff steht. Von dem Zahnrad 30 führt in einer Radialebene eine lichtdurchlässige Ringscheibe 31 nach innen. Die Ringscheibe 31 trägt einen gegen die Deckplatte 12 gerichteten Zylinderabschnitt 32. Der Zylinderabschnitt 32 ist an seinem deckplattenseitigen Ende durch eine Stirnplatte 33 geschlossen. Die Stirnplatte 33 trägt an ihrem Außenumfang eine kreisringförmige Codespur 34.

Die an die erste Codescheibe 3 axial anschließende zweite Codescheibe 4 weist ein kreisringförmiges Zahnrad 40 auf, welches mit seiner äußeren Umfangszahnung ebenfalls in Eingriff steht mit dem ersten Antriebszahnrad 21. Von dem Zahnrad 40 führt eine lichtdurchlässige Ringscheibe 41 nach innen, die einen Zylinderabschnitt 42 trägt. Der Zylinderabschnitt 42 ragt gegen die Deckplatte 12 und umschließt koaxial den Zylinderabschnitt 32 der ersten Codescheibe 3. An seinem deckplattenseitigen Ende trägt der Zylinderabschnitt 42 eine innere Kreisringscheibe 43, auf welcher eine Codespur 44 angebracht ist. An der der Deckplatte 12 zugewandten Seite des Zahnrades 40 schließt sich axial ein weiteres kreisringförmiges Zahnrad 45 mit Außenverzahnung an.

Die sich an die zweite Codescheibe 4 axial anschließende dritte Codescheibe 5 weist ein kreisringförmiges Zahnrad 50 auf, welches an seinem Innenumfang eine Kreisringscheibe 53 mit einer aufgebrachten Codespur 54 trägt.

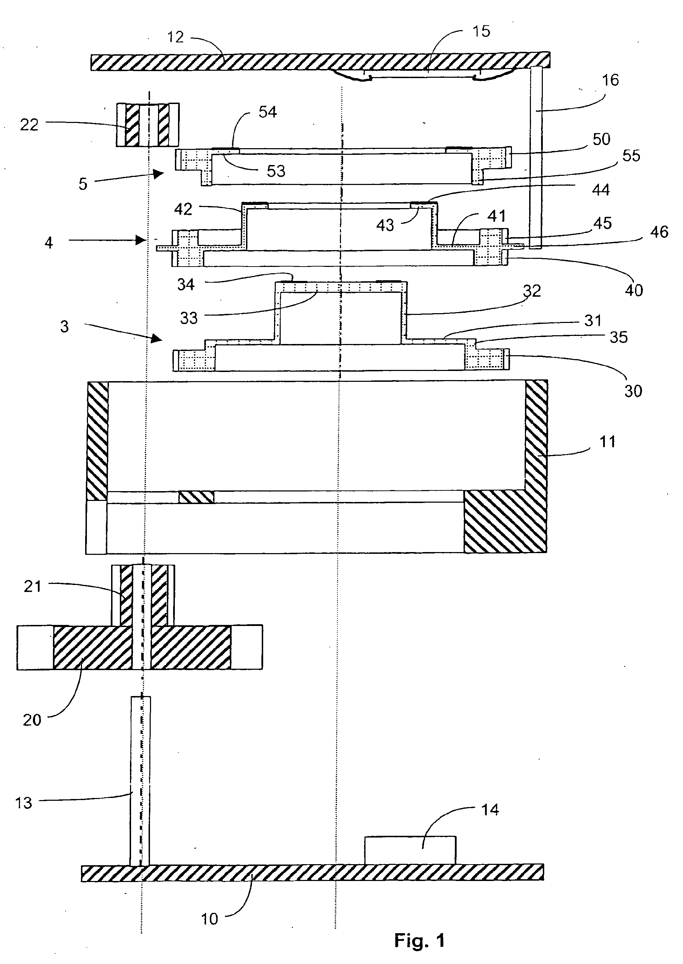

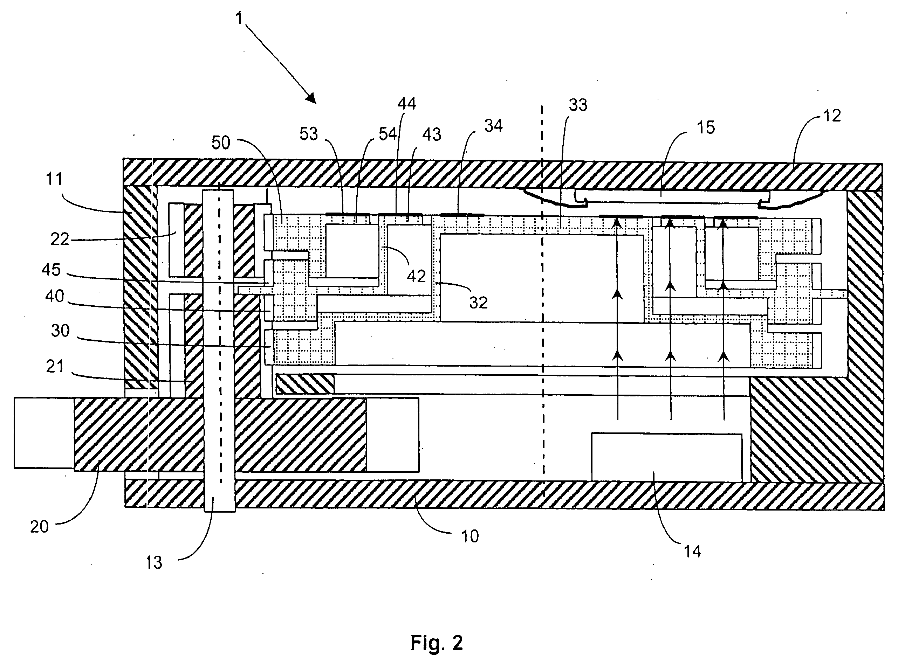

Wie aus den Figuren 1 und 2 erkennbar ist, sind die Codescheiben 3, 4 und 5 frei drehbar aneinander gelagert. Hierzu greift die erste Codescheibe 3 mit einer den Übergang von dem Zahnrad 30 zu den Stegen 31 bildenden Schulter 35 in den Innenumfang des Zahnrades 40 der zweiten Codescheibe 4. Die dritte Codescheibe 5 greift mit einem zylindrischen Ansatz 55 in den Innenumfang des Zahnrades 45 der zweiten Codescheibe 4.

Auf der Drehachse 13 sitzt oberhalb des ersten Antriebszahnrades 21 ein zweites Antriebszahnrad 22. Das zweite Antriebszahnrad 22 ist durch einen über die Zahnräder 40 und 45 hinausragenden Außenflansch 46 der zweiten Codescheibe 44 von dem ersten Antriebszahnrad 21 getrennt, so dass die Antriebszahnräder 21 und 22 sich unanhängig voneinander drehen können. Das zweite Antriebszahnrad 22 steht mit seiner Außenzahnung in Eingriff mit dem deckblattenseitigen Zahnrad 45 der zweiten Codescheibe 4 und mit dem Zahnrad 50 der dritten Codescheibe 5.

Die Stirnplatte 33 der ersten Codescheibe 3, die Kreisringscheibe 43 der zweiten Codescheibe 4 und die Kreisringscheibe 53 der dritten Codescheibe 5 liegen konzentrisch in einer gemeinsamen radialen Ebene, wie dies in Figur 2 sichtbar ist. Die Codespur 44 der zweiten Codescheibe 4 schließt sich dabei konzentrisch an den Außenumfang der Codespur 34 der ersten Codescheibe 3 an. Die Codespur 54 der dritten Codescheibe 5 schließt sich konzentrisch an den Außenumfang der Codespur 44 der zweiten Scheibe 4 an.

Das erste Antriebszahnrad 21 treibt die erste Codescheibe 3 und die zweite Codescheibe 4 über die jeweiligen Zahnräder 30 und 40 nach Art eines Differenzzahngetriebes an. Hierzu weist das Zahnrad 40 der zweiten Codescheibe 4 eine größere Zahnzahl auf als das Zahnrad 30 der ersten Codescheibe 3. In dem dargestellten Ausführungsbeispiel weist das erste Antriebszahnrad 15 Zähne auf, das Zahnrad 30 der ersten Codescheibe 3 weist 60 Zähne auf und das Zahnrad 40 der zweiten Codescheibe 4 weist 64 Zähne auf.

In entsprechender Weise treibt die zweite Codescheibe 4 die dritte Codescheibe 5 in der Art eines Differenzzahlengetriebes an. Hierzu weist das deckblattenseitige Zahnrad 45 eine geringere Zahnzahl auf als das Zahnrad 50 der dritten Codescheibe 5. Im dargestellten Ausführungsbeispiel weist das mit den Zahnrädern 45 und 50 in Eingriff stehende zweite Antriebszahnrad 22 fünfzehn Zähne auf und das deckblattenseitige Zahnrad 45 der zweiten Codescheibe 4 weist 60 Zähne auf und das Zahnrad 50 der dritten Codescheibe 5 weist 64 Zähne auf.

Auf der Grundplatte 10 sitzt ein Lichtsender 14, der über die auf der Grundplatte 10 ausgebildeten Leiterbahnen gespeist wird. Der Lichtsender 14 ist exzentrisch zur Achse des Gehäuseteils 11 und der Codescheiben 3, 4 und 5 angeordnet, so dass sein gebündeltes Licht die Codespuren 34, 44 und 54 durchstrahlt. Oberhalb der Codespuren 34, 44 und 54 ist an der Deckplatte 12 eine Abtastung 15 angeordnet, die auf einem Halbleiter-Chip ausgebildete lichtempfindliche Sensoren aufweist. Der Halbleiter-Chip der Abstastung 15 kann als SMD-Element oder Chip on board auf der als Leiterplatte ausgebildeten Deckplatte 12 angebracht werden. Elektrische Leitungen 16 verbinden die Leiterplatte der Grundplatte 10 mit der Leiterplatte der Deckplatte 12.

Die Codespuren 34, 44 und 54 der Codescheiben 3, 4 und 5 sind vorzugsweise als absolute Codierung ausgebildet, wobei jede Codespur 34, 44 und 54 in einem Pseudorandom-Code in 32 Winkelschritte unterteilt ist. Die Winkelschritte werden jeweils mit mindestens 2 x 5 Bit abgetastet, so dass sich eine Redundanz ergibt. Beim Einschalten der Abtastung kann somit der Winkelwert x und der Winkelwert x + n (n = mindestens 1) jeder einzelnen Codespur 34, 44 und 54 gelesen werden und dadurch lässt sich eine praktisch fehlerfreie Ablesung des Absolutwerts der Winkelstellung der Codescheiben 3, 4 und 5 beim Einschalten gewährleisten.

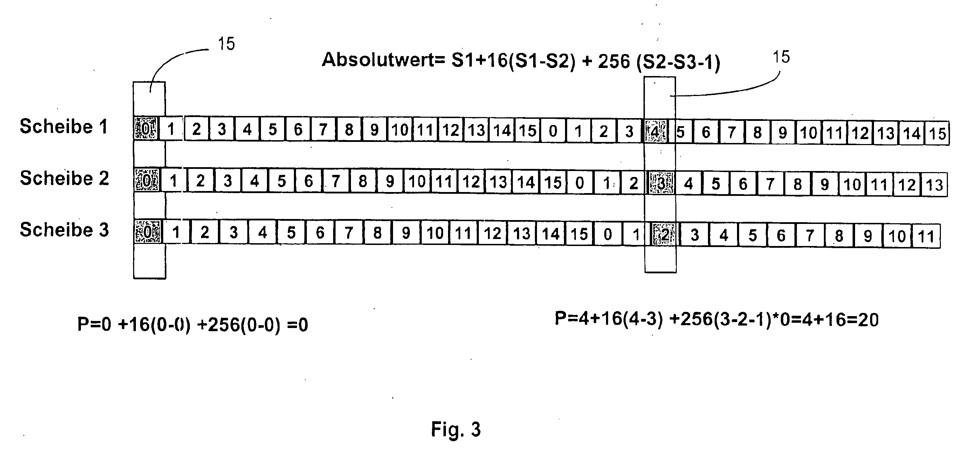

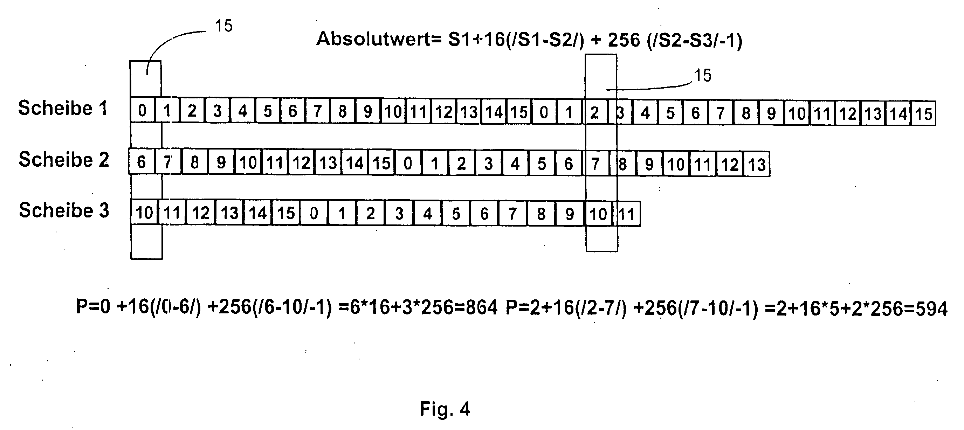

Anhand der Figuren 3 und 4 wird die Funktionsweise der Codierung erläutert.

Das von der Maßverkörperung über das Eingangszahnrad 20 angetriebene erste Antriebszahnrad 21 mit 15 Zähnen, treibt einerseits die erste Codescheibe 3 über deren Zahnrad 30 mit 60 Zähnen an und andererseits die zweite Codescheibe 4 über deren Zahnrad 40 mit 64 Zähnen. Nach vier Umdrehungen des Eingangszahnrades 20 hat somit die erste Codescheibe 3 eine volle Umdrehung ausgeführt. Die zweite Codescheibe 4 dreht sich entsprechend der größeren Zähnezahl um 1/16 langsamer als die erste Codescheibe 3. Da die zweite Codescheibe 4 mit dem Zahnrad 45 mit 60 Zähnen mit dem zweiten Antriebszahnrad 22 mit 15 Zähnen in Eingriff steht und dieses zweite Antriebszahnrad 22 mit seinen 15 Zähnen wiederum in das Zahnrad 50 mit 64 Zähnen der dritten Codescheibe 5 eingreift, dreht sich die dritte Codescheibe 5 Ihrerseits um 1/16 langsamer als die zweite Codescheibe 4.

Der Absolutwert der Codiereinheit ergibt sich somit aus dem Wert S1 der Codespur 34 der ersten Codescheibe 3 plus der 16-fachen Differenz der Werte S1 der Codespur 34 der ersten Codescheibe und S2 der Codespur 44 der zweiten Codescheibe 4 plus der 256-fachen Differenz der Werte S2 der Codespur 44 der zweiten Codescheibe 4 und S3 der Codespur 54 der dritten Codescheibe 5. Figur 3 zeigt zum einen die Nullstellung der Codiereinheit, bei welcher die Codespuren 34, 44 und 54 der drei Codescheiben 3, 4 und 5 jeweils den Wert 0 anzeigen. Die rechte Abtastung entspricht einem Wert von 20 Meßwertzyklen. Figur 4 zeigt weitere Beispiele, bei welchen sich 864 bzw. 594 Meßwertzyklen ergeben.

Es ist offensichtlich, dass anstelle von drei Codescheiben 3, 4 und 5 auch nur zwei Codescheiben oder auch mehr als 3 Codescheiben verwendet werden können, wobei jeweils die aneinander anschließenden Codescheiben über ein Differenzzahngetriebe gekuppelt sind. Damit kann der Zählbereich der Codiereinheit den jeweiligen Anforderungen angepasst werden.

Weiter ist ohne weiteres ersichtlich, dass die Erfindung nicht auf die in dem dargestellten Ausführungsbeispiel angegebenen Zähnezahlen von 15, 60 und 64 beschränkt ist.

Andere Kombinationen von Zähnezahlen sind ebenfalls möglich und ergeben eine entsprechend modifizierte Auswertung.

### Bezugszeichenliste

- 1: Gehäuse
- 3: erste Codescheibe
- 4: zweite Codescheibe
- 5: dritte Codescheibe

- 10: Grundplatte
- 11: Gehäuseteil
- 12: Deckplatte
- 13: Drehachse
- 14: Lichtsender
- 15: Abtastung
- 16: Verbindung

- 20: Eingangszahnrad
- 21: erstes Antriebsrad
- 22: zweites Antriebsrad

- 30: Zahnrad
- 31: Ringscheibe
- 32: Zylinderabschnitt
- 33: Stirnplatte
- 34: Codespur
- 35: Schulter

- 40: Zahnrad
- 41: Ringscheibe
- 42: Zylinderabschnitt
- 43: Kreisringscheibe
- 44: Codespur
- 45: Zahnrad
- 46: Außenflansch

- 50: Zahnrad
- 53: Kreisringscheibe
- 54: Codespur
- 55: Zylindrischer Ansatz

## Patentansprüche

1. Vorrichtung zur Messung der Position, des Weges oder des Drehwinkels eines Objektes, mit einer mit dem Objekt verbindbaren abtastbaren Maßverkörperung, die einem Positionsbereich des Objektes Messwerte zuordnet, wobei sich diese Messwerte in aufeinanderfolgenden Positionsbereichen des Objektes zyklisch wiederholen, und mit einer Codiereinheit, die die Anzahl der durchlaufenen Messwertzyklen codiert und wenigstens zwei über Untersetzungsgetriebe von der Maßverkörperung angetriebene Codescheiben aufweist, wobei die Codescheiben (3, 4, 5) eine absolute Winkelcodierung (34, 44, 54) aufweisen, wobei die Codescheiben (3, 4, 5) koaxial angeordnet sind und axial gegeneinander versetzt angeordnete Zahnräder (30, 40, 45, 50) aufweisen, wobei die jeweils aufeinanderfolgenden Codescheiben (3, 4 bzw. 4, 5) in der Weise durch ein Differenzzahngetriebe (21, 30, 40 bzw. 22, 45, 50) gekuppelt sind, dass sie gemeinsam mittels eines Antriebszahnrades 21 bzw. 22) angetrieben werden und ihre Zahnräder (30, 40, 45, 50) jeweils unterschiedliche Zahnzahlen aufweisen, und wobei die Anzahl der durchlaufenen Messwertzyklen aus der gegenseitigen Winkelposition der Codescheiben (3, 4, 5) bestimmt wird,
**dadurch gekennzeichnet, dass** die Zahnräder (30, 40, 45, 50) sämtlicher Codescheiben (3, 4, 5) kreisringförmig ausgebildet sind, dass die Codescheiben frei drehbar aneinander gelagert sind, dass die Codespuren (34, 44, 54) der Winkelcodierungen der Codescheiben, (3, 4, 5) sich in einer Ebene auf konzentrisch angeordneten Kreisringscheiben (33, 43, 53) im freien Innenraum der Zahnräder (30, 40, 45, 50) befinden und dass die Codespuren (34, 44, 54) sämtlicher Codescheiben (3, 4, 5) von einem gemeinsamen Lichtsender (14) mit im freien Innenraum der Zahnräder (30, 40, 45, 50) verlaufendem Lichtweg durchstrahlt werden und durch eine die Codespuren (34, 44, 54) sämtlicher Codescheiben (3, 4, 5) radial überdeckende Abtastung (15) abgetastet werden.

2. Vorrichtung nach Anspruch 1,
**dadurch gekennzeichnet, dass** zwei Zahnräder (30, 40 bzw. 45, 50) der jeweils aufeinanderfolgenden Codescheiben (3, 4 bzw. 4, 5) durch ein gemeinsames Antriebszahnrad (21 bzw. 22) angetrieben werden, welches am Außenumfang in die zwei Zahnräder (30, 40 bzw. 45, 50) eingreift und sich axial über die zwei Zahnräder (30, 40 bzw. 45, 50) erstreckt.

3. Vorrichtung nach Anspruch 1 oder 2
**dadurch gekennzeichnet, dass** der Lichtsender (14) auf einer Grundplatte (10) angeordnet ist, die die Lagerung der Codescheiben (3, 4, 5) und der Antriebszahnräder (21, 22) trägt, und dass die Abtastung (15) an einer der Grundplatte (10) entgegengesetzten Deckplatte (12) angeordnet ist.

4. Vorrichtung nach Anspruch 3,
**dadurch gekennzeichnet**, das die Grundplatte (10) und die Deckplatte (12) als Leiterplatten ausgebildet sind.

5. Vorrichtung nach Anspruch 3 oder 4,
**dadurch gekennzeichnet, dass** die Grundplatte (10) und die Deckplatte (12) ein Gehäuseteil (11) axial beiderends abschließen, welches die Codescheiben (3, 4, 5) aufnimmt.

6. Vorrichtung nach einem der Ansprüche 1 bis 5,
**dadurch gekennzeichnet, dass** die Codescheiben (3, 4, 5) mit ihren jeweiligen Zahnrädern (30, 40, 45, 50) und ihren die Codespuren (34, 44, 45) tragenden Kreisringscheiben (33, 43, 53) einstückige Spritzgussteile aus einem lichttransparenten Kunststoff sind

7. Vorrichtung nach einem der vorhergehenden Ansprüche,
**dadurch gekennzeichnet, dass** die komplette Codiereinheit als elektronisches Bauteil ausgebildet ist, das zur Bestückung von Leiterplatten geeignet ist.

8. Vorrichtung nach einem der vorhergehenden Ansprüche,
**dadurch gekennzeichnet, dass** sich die Untersetzungsverhältnisse, mit welchen zwei jeweils aufeinanderfolgende Codescheiben (3, 4 bzw. 4, 5) angetrieben werden, um 1/2ⁿ unterscheiden.

9. Vorrichtung nach Anspruch 8,
**dadurch gekennzeichnet, dass** die Antriebszahnräder (21, 22) jeweils 15 Zähne aufweisen und die eine Codescheibe 60 Zähne und die andere 64 Zähne aufweist.

10. Vorrichtung nach Anspruch 9,
**dadurch gekennzeichnet, dass** die Codiereinheit drei Codescheiben (3, 4, 5) aufweist, so dass 4096 Messwertzyklen gezählt werden können.

11. Vorrichtung nach einem der vorhergehenden Ansprüche,
**dadurch gekennzeichnet, dass** die Codescheiben (3, 4, 5) jeweils eine absolut codierte Winkelteilung mit 32 Winkelschritten aufweisen.

12. Vorrichtung nach Anspruch 11,
**dadurch gekennzeichnet, dass** die Codierung der Winkelteilung durch einen Pseudorandom-Code mit jeweils mindestens 2 x 5 Bit gebildet ist.

## Claims

1. Device for measuring the position, the path or the angle of rotation of an object, comprising a scannable material measure which can be connected to the object and assigns measurement values to a position range of the object, these measurement values being cyclically repeated in successive position ranges of the object, and comprising a coding unit, which codes the number of passed-through measurement value cycles and has at least two code discs driven via reduction gears of the material measure, wherein the code discs (3, 4, 5) have an absolute angle coding (34, 44, 54), wherein the code discs (3, 4, 5) are coaxially disposed and have axially mutually offset gears (30, 40, 45, 50), wherein the respectively successive code discs (3, 4 and 4, 5) are coupled in such a way by a differential gearing (21, 30, 40 and 22, 45, 50) that they are jointly driven by means of a drive gear (21 and 22) and their gears (30, 40, 45, 50) respectively have different tooth numbers, and wherein the number of passed-through measurement value cycles is determined from the mutual angular position of the code discs (3, 4, 5), **characterized in that** the gears (30, 40, 45, 50) of all code discs (3, 4, 5) are of annular configuration, **in that** the code discs are mounted one against the other such that they are freely rotatable, **in that** the code tracks (34, 44, 54) of the angle codings of the code discs (3, 4, 5) are located in a single plane on concentrically disposed annular discs (33, 43, 53) in the free interior of the gears (30, 40, 45, 50), and **in that** the code tracks (34, 44, 54) of all code discs (3, 4, 5) are irradiated by a joint light transmitter (14) with light path running in the free interior of the gears (30, 40, 45, 50) and are scanned by a scanner (15) radially sweeping the code tracks (34, 44, 54) of all code discs (3, 4, 5).

2. Device according to Claim 1, **characterized in that** two gears (30, 40 and 45, 50) of the respectively successive code discs (3, 4 and 4, 5) are driven by a joint drive gear (21 and 22), which at the outer periphery engages in the two gears (30, 40 and 45, 50) and extends axially over the two gears (30, 40 and 45, 50) .

3. Device according to Claim 1 or 2, **characterized in that** the light transmitter (14) is disposed on a base plate (10) supporting the mounting of the code discs (3, 4, 5) and of the drive gears (21, 22), and **in that** the scanner (15) is disposed on a cover plate (12) placed opposite the base plate (10).

4. Device according to Claim 3, **characterized in that** the base plate (10) and the cover plate (12) are configured as printed circuit boards.

5. Device according to Claim 3 or 4, **characterized in that** the base plate (10) and the cover plate (12) close off axially at both ends a housing part (11), which accommodates the code discs (3, 4, 5).

6. Device according to one of Claims 1 to 5, **characterized in that** the code discs (3, 4, 5) with their respective gears (30, 40, 45, 50) and their annular discs (33, 43, 53) bearing the code tracks (34, 44, 54) are one-piece injection mouldings made of a light-transparent plastic.

7. Device according to one of the preceding claims, **characterized in that** the complete coding unit is configured as an electronic component, which is suitable for the assembly of printed circuit boards.

8. Device according to one of the preceding claims, **characterized in that** the gear reduction ratios with which two respectively successive code discs (3, 4 and 4, 5) are driven differ by 1/2ⁿ.

9. Device according to Claim 8, **characterized in that** the drive gears (21, 22) respectively have 15 teeth and one code disc has 60 teeth and the other 64 teeth.

10. Device according to Claim 9, **characterized in that** the coding unit has three code discs (3, 4, 5), so that 4096 measurement value cycles can be counted.

11. Device according to one of the preceding claims, **characterized in that** the code discs (3, 4, 5) respectively have an absolutely coded angle scale comprising 32 angular steps.

12. Device according to Claim 11, **characterized in that** the coding of the angle scale is formed by a pseudorandom code having respectively at least 2 x 5 bits.

## Revendications

1. Dispositif pour mesurer la position, le trajet ou l'angle de rotation d'un objet, comprenant une mesure matérialisée pouvant être balayée et pouvant être reliée à l'objet, qui associe à une zone de position de l'objet des valeurs de mesure, ces valeurs de mesure se répétant de manière cyclique dans des zones de position successives de l'objet, et comprenant une unité de codage qui code le nombre de cycles de mesure continus et présente au moins deux disques de codage entraînés par la mesure matérialisée via des réducteurs, les disques de codage (3, 4, 5) présentant un codage angulaire absolu (34, 44, 54), les disques de codage (3, 4, 5) étant disposés de façon coaxiale et présentant des roues dentées (30, 40, 45, 50) disposées de manière axialement décalées les unes par rapport aux autres, les disques de codage respectivement successifs (3, 4 ou 4, 5) étant couplés par un engrenage denté différentiel (21, 30, 40 ou 22, 45, 50) de telle sorte qu'ils sont entraînés conjointement au moyen d'une roue dentée d'entraînement (21 ou 22) et que leurs roues dentées (30, 45, 45, 50) présentent respectivement des nombres de dents différents, et le nombre de cycles de valeurs de mesure continus étant déterminé à partir de la position angulaire mutuelle des disques de codage (3, 4, 5),
**caractérisé en ce que**
les roues dentées (30, 40, 45, 50) de tous les disques de codage (3, 4, 5) sont configurés en forme d'anneau circulaire et les disques de codage sont logés de manière librement rotative les uns contre les autres, les pistes de codage (34, 44, 54) des codages angulaires des disques de codage (3, 4, 5) se trouvent dans un plan sur des disques annulaires circulaires (33, 43, 53) et disposées de manière concentrique dans l'espace intérieur libre des roues dentées (30, 40, 45, 50), et les pistes de codage (34, 44, 54) de tous les disques de codage (3, 4, 5) sont traversées par un trajet lumineux s'étendant dans l'espace intérieur libre des roues dentées (30, 40, 45, 50) et provenant de l'émetteur de lumière (14), et sont balayées par un dispositif de balayage (15) couvrant radialement les pistes de codage (34, 44, 54) de tous les disques de codage (3, 4, 5).

2. Dispositif selon la revendication 1,
**caractérisé en ce que**
deux roues dentées (30, 40 ou 45, 50) des disques de codage respectivement successifs (3, 4 ou 4, 5) sont entraînées par une roue dentée d'entraînement commune (21 ou 22) qui s'engage au niveau de sa périphérie extérieure dans les deux roues dentées (30, 40 ou 45, 50) et s'étend axialement au-delà des deux roues dentées (30, 40 ou 45, 50).

3. Dispositif selon la revendication 1 ou 2,
**caractérisé en ce que**
l'émetteur de lumière (14) est disposé sur une plaque de base (10) qui porte le logement des disques de codage (3, 4, 5) et les roues dentées d'entraînement (21, 22), et le dispositif de balayage (15) est monté sur une plaque de couvercle (12) opposée à la plaque de base (10).

4. Dispositif selon la revendication 3,
**caractérisé en ce que**
la plaque de base (10) et la plaque de couvercle (12) sont des cartes de circuit imprimé.

5. Dispositif selon la revendication 3 ou 4,
**caractérisé en ce que**
la plaque de base (10) et la plaque de couvercle (12) ferment axialement aux deux extrémités une partie de boîtier (11), qui reçoit les disques de codage (3, 4, 5).

6. Dispositif selon l'une des revendications 1 à 5,
**caractérisé en ce que**
les disques de codage (3, 4, 5), avec leurs roues dentées respectives (30, 40, 45, 50) et leurs disques annulaires circulaires (33, 43, 53) portant les pistes de codage (34, 44, 54), sont des pièces moulées par injection faites d'une seule pièce en une matière plastique translucide.

7. Dispositif selon l'une des revendications précédentes,
**caractérisé en ce que**
l'unité de codage complète un composant électronique approprié pour le garnissage de cartes de circuit imprimé.

8. Dispositif selon l'une des revendications précédentes,
**caractérisé en ce que**
les rapports de réduction avec lesquels sont entraînés deux disques de codage respectivement successifs (3, 4 ou 4, 5) se différencient de 1/2ⁿ.

9. Dispositif selon la revendication 8,
**caractérisé en ce que**
les roues dentées d'entraînement (21, 22) présentent respectivement 15 dents, le premier disque de codage présente 60 dents et l'autre présente 64 dents.

10. Dispositif selon la revendication 9,
**caractérisé en ce que**
l'unité de codage présente trois disques de codage (3, 4, 5), de telle sorte que l'on peut compter 4 096 cycles de valeurs de mesure.

11. Dispositif selon l'une des revendications précédentes,
**caractérisé en ce que**
les disques de codage (3, 4, 5) présentent respectivement une division angulaire codée de manière absolue avec 32 pas angulaires.

12. Dispositif selon la revendication 11,
**caractérisé en ce que**
le codage de la division angulaire est formé par un code pseudo-aléatoire avec respectivement au moins 2 x 5 bits.
